Europäisches Patentamt

European Patent Office

Office européen des brevets

(19)

(11) **EP 1 174 719 A1**

(12) **EUROPÄISCHE PATENTANMELDUNG**

(43) Veröffentlichungstag:
**23.01.2002   Patentblatt 2002/04**

(51) Int Cl.[7]: **G01R 15/24**

(21) Anmeldenummer: **00810605.6**

(22) Anmeldetag: **10.07.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(71) Anmelder: **ABB RESEARCH LTD.**
**8050 Zürich (CH)**

(72) Erfinder: **Bohnert, Klaus**
**5452 Oberrohrdorf (CH)**

(74) Vertreter: **ABB Patent Attorneys**
**c/o ABB Business Services Ltd, Intellectual Property (SLE-I), Haselstrasse 16/699**
**5401 Baden (CH)**

(54) **Faseroptischer Stromsensor**

(57)    Ein optischer Stromsensor mit einem Reflexionsinterferometer (1,10) weist in seiner faseroptischen Zuleitung (2) einen polarisationserhaltenden ersten Faserzweig (20) für zwei vorwärtslaufende orthogonal polarisierte Wellen und einen polarisationserhaltenden zweiten Faserzweig (20') für zwei rückwärtslaufende orthogonal polarisierte Wellen auf. Dabei sind die zwei Faserzweige (20,20') über einen sensorseitigen Koppler (8) miteinander verbunden sind. Der erste Faserzweig (20) ist mit einer Lichtquelle (4) und der zweite Faserzweig (20') mit dem Detektor (5) verbunden. Mit mindestens einem der Faserzweige (20,20') ist ein Mittel zur Phasenverschiebung (7) wirkverbunden. Dadurch lässt sich eine quasi-statische Kontrolle des Phasenunterschiedes der Wellen erreichen, so dass an die Mittel zur Phasenverschiebung geringere Anforderungen gestellt werden können als an die üblicherweise bei derartigen Stromsensoren verwendeten Phasenmodulatoren und Signalprozessoren.

Fig. 1

EP 1 174 719 A1

## Beschreibung

### Technisches Gebiet

Die Erfindung bezieht sich auf einen faseroptischen Stromsensor mit einem Reflexionsinterferometer gemäss Oberbegriff des Patentanspruches 1, einem Verfahren zur Einstellung eines Arbeitspunktes in einem derartigen Stromsensor gemäss Oberbegriff des Patentanspruchs 9 und einem Verfahren zur Strommessung mittels eines derartigen Stromsensors gemäss Oberbegriff des Patentanspruchs 13.

### Stand der Technik

Ein gattungsgemässer faseroptischer Stromsensor ist aus DE-A-4'224'190 und G. Frosio et al., "Reciprocal reflection interferometer for a fiber-optic Faraday current sensor", Applied Optics, Vol. 33, No. 25, Seite 6111-6122 (1994) bekannt. Er weist eine spulenförmig gewickelte, magneto-optisch aktive Sensorfaser auf, welche einen Stromleiter umschliesst. An einem Ende ist die Sensorfaser verspiegelt, am anderen Ende ist sie über ein Phasenverzögerungselement mit einer polarisationserhaltenden optischen Zuleitungsfaser verbunden, über welche sich Licht in die Sensorfaser ein- beziehungsweise auskoppeln lässt. Die Zuleitungsfaser propagiert dabei zueinander orthogonal linear polarisierte optische Wellen. Mit Hilfe eines faseroptischen Phasenverzögerers werden diese vor Eintritt in die Sensorspule in zwei zirkular polarisierte Wellen umgewandelt, wobei die zwei zirkular polarisierten Wellen einen zueinander entgegengesetzten Drehsinn aufweisen. Nach Durchlaufen der Sensorspule werden die zwei zirkularen Wellen am Ende der Spule reflektiert, wobei sie mit vertauschtem Polarisationssinn durch die Spule zurücklaufen.

Fliesst nun ein Strom durch den Stromleiter, so bewirkt das magnetische Feld des Stroms eine differentielle Phasenverschiebung zwischen den beiden zirkularen optischen Wellen. Dieser Effekt wird magneto-optischer oder Faraday-Effekt genannt. Durch das zweimalige Durchlaufen der Spule akkumulieren die Wellen eine differentielle Phasenverschiebung von $\Delta\Phi_s = 4\,V\,N\,I$, wobei V die Verdet-Konstante der Faser, N die Anzahl der Faserwindungen in der Spule und I den Strom durch den Stromleiter bezeichnet.

Die zirkularen Wellen werden beim Austritt aus der Spule im Phasenverzögerer wieder in orthogonale linear polarisierte Wellen verwandelt und über die Zuleitungsfaser zu einem Detektionssystem geführt. Die Polarisationsrichtungen der zurücklaufenden orthogonalen Wellen sind im Vergleich zu den vorwärtslaufenden Wellen vertauscht. Die durch den Strom verursachte Phasenverschiebung lässt sich detektieren, indem die zwei reflektierten linear polarisierten Wellen in einem an die Zuleitungsfaser anschliessenden Polarisator zur Interferenz gebracht werden.

Um ein nutzbares Interferenzsignal zu erreichen muss der effektive Arbeitspunkt des Interferometers in einen linearen Bereich einer cos-förmigen Interferenzfunktion gebracht werden. Dies erfolgt mittels einer Modulationseinheit mit einem Phasenmodulator, welcher die Doppelbrechung in der Zuleitungsfaser und somit eine differentielle Phase der beiden Wellen verändert. Da sowohl vor- wie auch rückwärtslaufende Wellen denselben Phasenmodulator passieren, muss dieser mit einer an die Umlaufzeit der Wellen angepassten Frequenz schwingen, um die differentielle Phase der beiden interferierenden Wellen nicht-reziprok zu modulieren. Ohne Modulationseinheit wäre der Phasenunterschied der zwei interferierenden Wellen gleich Null.

Die Modulationsfrequenz entspricht idealerweise dem inversen Wert der doppelten Umlaufzeit des Lichts im Interferometer. Die Frequenz der Modulation liegt typischerweise im Bereich zwischen 100 kHz und einigen MHz und wird unter anderem durch die Länge der Faserverbindung zur Sensorfaser, das heisst der Zuleitungsfaser, bestimmt.

Durch geeignete Demodulation lässt sich die strominduzierte Phasenverschiebung bestimmen. Die Demodulationstechniken sind dieselben, welche für faseroptische Gyroskope benutzt werden und welche beispielsweise in R. A. Bergh et al, "An Overview of fiber-optic gyroscopes", J. Lightwave Technol. 2, 91'107 (1984) beschrieben sind. Man unterscheidet dabei im wesentlichen zwischen open-loop und closed-loop Konfigurationen.

Damit der faseroptische Stromsensor in der Praxis einsatzfähig ist, benötigt er eine gute Langzeitstabilität. Leider weisen einfache Modulationseinheiten, beispielsweise solche mit piezoelektrischen Modulatoren, einen Drift in ihrer Amplitude auf, z.B. infolge von Temperaturänderungen. Im Stand der Technik werden deshalb relativ teure, möglichst stabile Modulationseinheiten verwendet, welche integriert optische Modulatoren oder Mittel zur Kompensation von Amplitudenschwankungen aufweisen. Derartige Mittel sind beispielsweise Messmittel zur Bestimmung der Amplitude der Phasenmodulation, um sie mittels eines zusätzlichen Regelkreises konstant zu halten. Diese Mittel führen jedoch zu einem komplizierten Aufbau des Sensors und erhöhen somit die Kosten.

### Darstellung der Erfindung

Es ist Aufgabe der Erfindung, einen faseroptischen Stromsensor in einer Reflektionskonfiguration zu schaffen, welcher eine gute Langzeitstabilität aufweist, ohne zu hohe Anforderungen an die Modulationseinheit, insbesondere an deren Auswerteelektronik zu stellen.

Diese Aufgabe löst ein faseroptischer Stromsensor mit den Merkmalen des Patentanspruches 1, ein Verfahren zur Einstellung eines Arbeitspunktes in einem derartigen Stromsensor mit den Merkmalen des Patentanspruchs 9 und ein Verfahren zur Strommessung mittels eines derartigen Stromsensors mit den Merkmalen des Patentanspruchs 13.

Im erfindungsgemässen Stromsensor propagieren vor- und rückwärtslaufende Wellen auf einem Teil ihrer Strecke in zwei getrennten Fasersegmenten, wobei mit mindestens einem dieser Fasersegmente ein Mittel zur Phasenverschiebung wirkverbunden ist. Als derartiges Mittel sind die bekannten Phasenmodulatoren geeignet. Dank der zwei Segmente wurde eine hin- und zurückgelaufene Welle nur einmal von demselben Modulator beeinflusst. Es ist somit möglich, mit einem quasi-statisch betriebenen Modulator den Arbeitspunkt in den Quadraturpunkt zu schieben und zusätzlich nicht strominduzierte, beispielsweise durch Temperaturänderungen hervorgerufene Schwankungen in der Phasendifferenz zweier gleichlaufender Wellen zu kompensieren. Hierfür reicht ein Modulator mit einem kleinen Frequenzband, beispielsweise von circa 5 Hz, aus.

Vorteilhaft am erfindungsgemässen Stromsensor ist ferner, dass die Länge der polarisationserhaltenden Faser nicht mehr an die Modulationsfrequenz angepasst sein muss, sondern willkürlich wählbar ist. Es gibt praktisch keine untere Grenze mehr für die Länge der Zuleitungsfaser, wodurch wiederum Kosten gespart werden können.

In einer Variante des erfindungsgemässen Verfahrens werden nicht nur temperatur- und durch andere Einflüsse induzierte Phasenverschiebungen quasi-statisch kompensiert, sondern es wird auch eine dynamische Modulation verwendet, welche mit einer dem zu messenden Wechselstrom entsprechenden Frequenz erfolgt. Dies lässt sich mit demselben Modulator durchführen oder mit einem zweiten Modulator. Im zweiten Fall ist der zweite Modulator vorzugsweise im anderen Faserzweig angeordnet.

Weitere vorteilhafte Ausführungsformen gehen aus den abhängigen Patentansprüchen hervor.

**Kurze Beschreibung der Zeichnungen**

Im folgenden wird der Erfindungsgegenstand anhand von bevorzugten Ausführungsbeispielen, welche in den beiliegenden Zeichnungen dargestellt sind, näher erläutert. Es zeigen:

Figur 1   einen faseroptischen Stromsensor gemäss der Erfindung;

Figur 2   eine graphische Darstellung einer Arbeitspunkteinstellung in einer quasi-statischen Phasenkontrolle;

Figur 3   einen Detektor und eine Modulationseinheit des erfindungsgemässen Stromsensors gemäss einer ersten Ausführungsform der Erfindung und

Figur 4   einen Detektor des erfindungsgemässen Stromsensors gemäss einer zweiten Ausführungsform der Erfindung.

**Wege zur Ausführung der Erfindung**

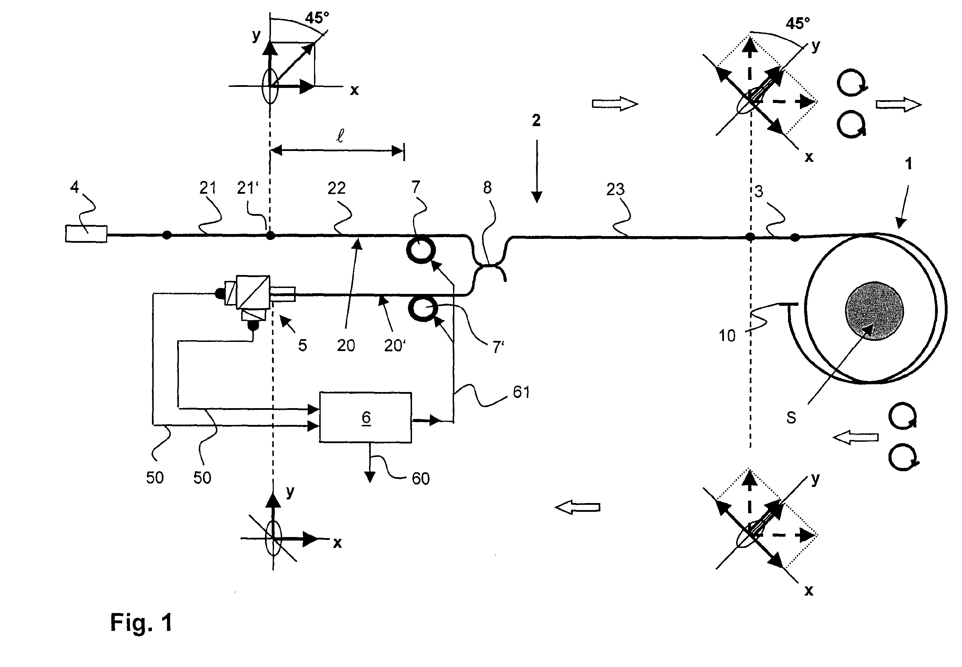

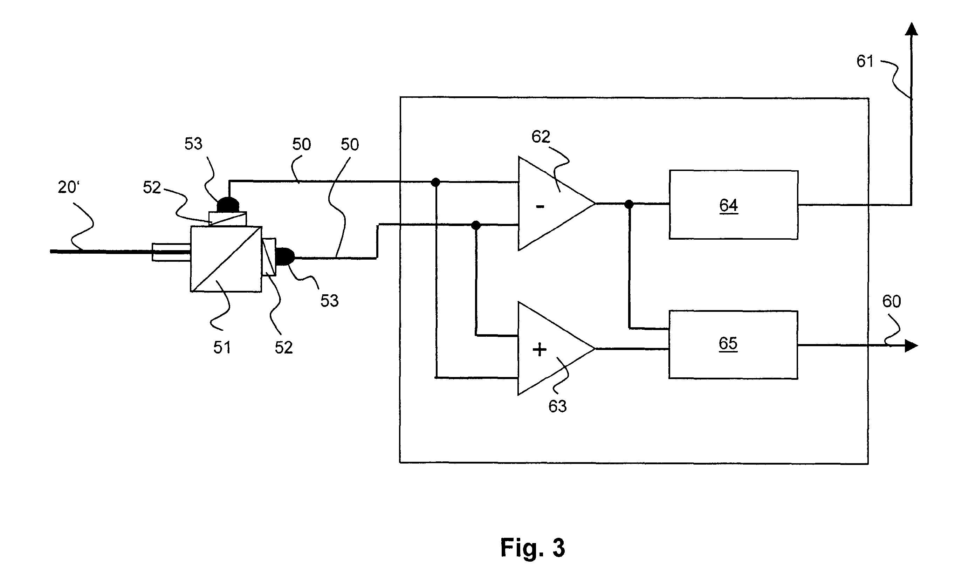

Figur 1 zeigt einen erfindungsgemässen faseroptischen Stromsensor mit einem Reflexionsinterferometer. Eine Sensorfaser 1 ist spulenförmig um einen Stromleiter L gewickelt. Sie weist vorzugsweise einen runden Kernquerschnitt auf und ist vorzugsweise aus Quarzglas gefertigt. Ein erstes Ende der Sensorfaser 1 ist mit einer faseroptischen Zuleitung 2 verbunden. Ein zweites Ende ist mit einem Reflektor 10 versehen. Im allgemeinen ist der Reflektor 10 durch eine Verspiegelung des zweiten Faserendes gebildet. Die Zuleitung 2 ist mindestens abschnittsweise doppelbrechend und damit polarisationserhaltend ausgebildet. Vorzugsweise weist sie zur Erzeugung der Doppelbrechung einen elliptischen Kernquerschnitt auf. Die Verwendung einer stress-induzierten doppelbrechenden Faser ist jedoch möglich. Die Verbindung der Zuleitung 2 mit der Sensorfaser 1 erfolgt über ein Phasenverzögerungselement 3, wobei hierfür vorzugsweise ein $\lambda/4$-Phasenverzögerungs-Fasersegment eingesetzt ist.

Ferner ist eine Lichtquelle 4 vorhanden, deren Licht durch die Fasern übermittelt wird. Als Lichtquelle eignen sich insbesondere solche mit einer kleinen Kohärenzlänge, insbesondere eine Superlumineszenzdiode, eine unter der Laserschwelle betriebene Laserdiode, eine LED oder eine breitbandige Faserlichtquelle. Der Sensor verfügt über einen Detektor 5, welcher durch die Sensorfaser propagiertes und zur Interferenz gebrachtes Licht detektiert. Dieser Detektor 5 ist über Detektorsignalleitungen 50 mit einem Signalprozessor 6 verbunden, welcher das Sensorsignal über eine Sensorsignalleitung 60 an eine nicht dargestellte Auswerteelektronik übermittelt.

Erfindungsgemäss weist die Zuleitung 2 zwei polarisationserhaltende Faserzweige 20,20' auf. Als Faserzweige 20,20' eignen sich insbesondere Fasersegmente mit einem elliptischen Kern. Die Faserzweige 20,20' weisen mindestens annähernd dieselbe optische Länge auf, das heisst sie sind innerhalb der Kohärenzlänge der Lichtquelle 4 gleich. Die optischen Wegunterschiede, welche zwei in unterschiedlichen Faserzweigen propagierende Moden oder Wellen akkumulieren, sind somit identisch. Die zwei Faserzweige sind parallel geschaltet und im Bereich ihrer sensorseitigen Enden über einen polarisationserhaltenden Koppler 8 miteinander verbunden. Im hier dargestellten bevorzugten Ausführungsbeispiel ist der Koppler 8 ein Faserkoppler mit einem elliptischen Kern, wobei seine Achsen so angeordnet sind, dass sie parallel zu den Achsen der Faserzweige 20,20' liegen. Es ist jedoch auch möglich, andere Arten von Kopplern zu verwenden. Die zwei Faserzweige 20,20' sind vorzugsweise so mit dem Koppler verbunden, dass die Richtungen der linearen Polarisationen der vorwärts (Zweig 20) und der zurücklaufenden (Zweig 20') Wellen bezüglich der Faserachsen gegenseitig vertauscht sind. Eine optische Welle, welche im ersten Zweig 20 parallel zur langen Kernachse schwingt, schwingt im zweiten Zweig 20' parallel zur kurzen Achse und umgekehrt.

Der erste Faserzweig, der Zuleitungszweig 20 ist an seinem anderen Ende mit der Lichtquelle 4 wirkverbunden. Der zweite Faserzweig, der Detektionszweig 20', ist mit dem Detektor 5 wirkverbunden.

Der Zuleitungszweig 20 ist im Übergang zur Lichtquelle 4 mit einem Polarisator 21 verbunden. Vorzugsweise ist der Polarisator 21 so gerichtet, dass seine Polarisationsrichtungen unter 45° zu den Hauptachsen des Faserzweig 20 liegen. In diesem Beispiel ist ein Faserpolarisator 21 eingesetzt, welcher über einen 45°-Spleiss 21' mit dem Zuleitungszweig 20 verbunden ist, Die Verwendung anderer Polarisatoren ist jedoch möglich.

Der Faserzweige 20 weist ferner vorzugsweise ein Dekohärenzelement 22 der Länge 1 auf. Dieses Dekohärenzelement 22 erzeugt in den sich im Zuleitungszweig 20 ausbreitenden vorwärtslaufenden Wellen einen differentiellen optische Wegunterschied, welche länger ist als die Kohärenzlänge der Lichtquelle 4. Dadurch werden störende Effekte infolge von Modenkopplung im nachfolgend beschriebenen Mittel zur Phasenverschiebung 7,7' verhindert. Befindet sich ein Modulator im Zweig 20', so ist er vorzugsweise um mindestens eine Strecke der Länge 1 vor dem Faserende bzw. dem Detektor 5 angeordnet.

Mindestens einer der zwei Faserzweige 20,20' ist mit einer Phasenverschiebungseinheit wirkverbunden. Die Phasenverschiebungseinheit entspricht eigentlich der bekannten Phasenmodulationseinheit und besteht im wesentlichen aus dem oben beschriebenen Signalprozessor 6 sowie mindestens einem mit diesem über eine Modulationssignalleitung 61 verbundenen Phasenmodulator 7,7'. Der mindestens eine Phasenmodulator 7,7' wird hier jedoch nicht in der bekannten Weise zur Modulation der Phasendifferenz eingesetzt, sondern dient als Mittel zur quasi-stationären Phasenverschiebung. Als Phasenmodulator 7 ist vorzugsweise ein piezo-elektrischer Modulator eingesetzt, wobei ein Teil des jeweiligen Faserzweigs 20,20' um einen piezoelektrischen Körper des Modulators 7 gewickelt ist. Es ist jedoch auch möglich, andere Modulatoren einzusetzen, insbesondere einen integriert-optischen Modulator, welcher auf dem elektro-optischen Effekt in einem Wellenleiter basiert.

In einer einfachsten Ausführungsform ist lediglich einer der zwei Faserzweige 20,20' mit einem Phasenmodulator 7 wirkverbunden, wobei die Auswahl des Faserzweigs beliebig ist. Im hier dargestellten Ausführungsbeispiel ist jedoch jeder Faserzweig 20,20' mit einem Phasenmodulator 7,7' wirkverbunden. Die zwei Phasenmodulatoren 7,7' sind vorzugsweise mit demselben Signalprozessor verbunden.

In Figur 1 sind die Polarisationen von im erfindungsgemässen Stromsensor vor- und rückwärts laufenden Wellen mit schmalen Pfeilen dargestellt. Zudem geben breite Pfeile die Ausbreitungsrichtung der Wellen an. Eine vorwärtslaufende optische Welle, welche von der Lichtquelle 4 emittiert wird, wird im Polarisator 21 linear polarisiert und über den 45° Spleiss als zwei zueinander orthogonale Polarisationen, in die polarisationserhaltende Zuleitungsfaser 2, hier in den Zuleitungszweig 20 eingekoppelt. Die zwei Polarisationen werden im folgenden auch als zwei orthogonale linear polarisierte Wellen bezeichnet. Das Dekohärenzelement 22 der Zuleitungsfaser 2 hat eine kohärenzschädigende Wirkung auf die Welle und erzeugt in den zwei propagierenden orthogonalen Polarisationen einen differentiellen optischen Wegunterschied, welcher bedeutend länger als die Kohärenzlänge der Lichtquelle 4 ist. Die Länge 1 des Dekohärenzelementes 21 muss entsprechend gewählt sein, wobei $\Delta L = 1 \ \Delta n_G$ erfüllt sein sollte, mit $\Delta L$ der Wegunterschied und $\Delta n_G$ dem Gruppenindex-Unterschied, welchen die zwei Polarisationen sehen.

Die orthogonalen Polarisationen der vorwärtslaufenden Welle durchlaufen den Einflussbereich des ersten Modulators 7 und gelangen durch den Koppler 8 und über ein weiteres polarisationserhaltendes Fasersegment 23 der Zuleitung 2 zum Phasenverzögerungselement 3. Hier werden die orthogonal polarisierten Wellen in zwei links- und rechts zirkular polarisierte Wellen verwandelt, wie in Figur 1 dargestellt ist. Die zirkularen Wellen durchlaufen die Sensorfaser 1, werden am Spulenende 10 reflektiert, vertauschen dabei ihre Polarisationszustände, laufen durch die Spule zurück und werden im $\lambda/4$-Verzögerer wieder in orthogonal linear polarisierte Wellen verwandelt, deren Polarisation jetzt senkrecht zur Polarisation der entsprechenden Wellen der Vorwärtsrichtung steht. Der gesamte differentielle Phasenunterschied der vor- und rücklaufenden Wellen ist, für den Fall, dass die Zweige 20,20' mindestens annähernd dieselbe optische Länge aufweisen, am detektorseitigen Faserende somit gleich Null im Falle, dass kein Strom durch den Stromleiter S fliesst und ungleich Null, wenn ein Strom fliesst. Die zurücklaufenden Wellen werden über den Koppler 8 und den Detektorzweig 20' geleitet, im Detektor 5 zur Interferenz gebracht und dadurch entstehende Interferenzsignale detektiert.

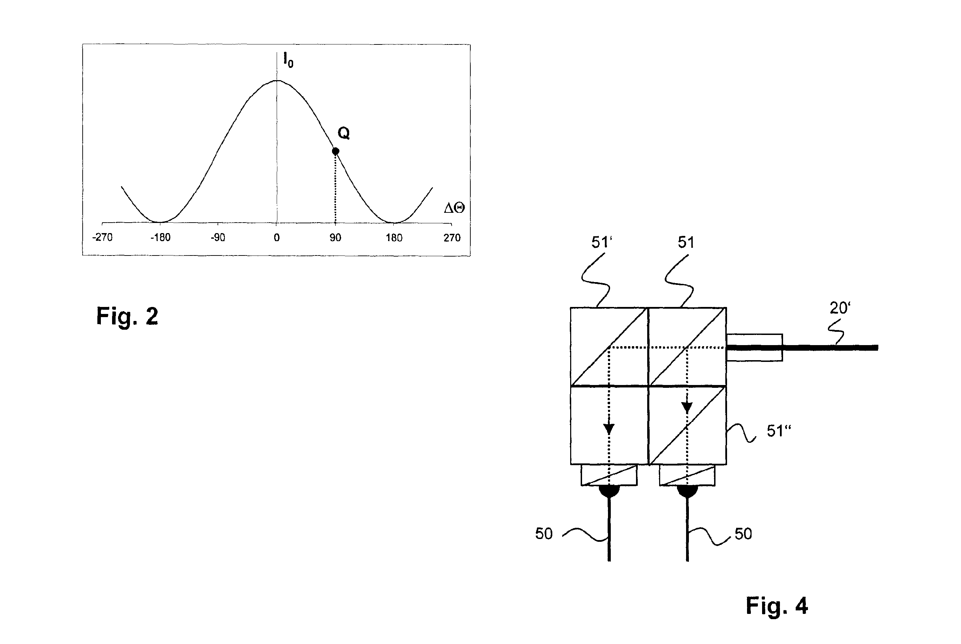

Die differentielle Phase der orthogonalen Polarisationen wird erfindungsgemäss mittels einer quasistationären Phasenkontrolle kontrolliert und somit ein geeigneter Arbeitspunkt eingestellt. Eine derartige quasi-stationäre Phasenkontrolle ist aus D. A. Jackson et al, "Elimination of drift in a single-mode optical fiber interferometer using a piezoelectrically stretched coiled fiber", Applied Optics, vol. 19, No. 17, 1980, bekannt, wo sie bei einem faseroptischen Mach-Zehnder Interferometer eingesetzt wird. Der Arbeitspunkt wird dabei im Quadraturpunkt Q gewählt, das heisst dass $\Delta\Theta = \Delta\Theta_1 + \Delta\Theta_2$ gleich $\pi/2 + m\pi$ gewählt wird, wobei m eine ganze Zahl ist. Die Einstellung des Arbeitspunktes ist in Figur 2 dargestellt. $\Delta\Theta$ ist dabei die kombinierte Phasendifferenz, welche die durch den Stromsensor propagierten Wellen in den zwei separaten Faserzweigen akkumuliert haben. $\Delta\Theta_1$ und $\Delta\Theta_2$ sind dabei die Phasendifferenzen in den zwei Zweigen. Im Falle, dass die zwei Faserzweige dieselbe optische Länge aufweisen, ist im stromlosen Zustand und aufgrund der umgekehrten Polarisation $\Delta\Theta_1$ gleich $-\Delta\Theta_2$.

Im erfindungsgemässen Sensor lassen sich entweder Phasen der orthogonalen Polarisationen der vorwärtslaufenden und/oder der rückwärtslaufenden Wellen kontrollieren.

Die Einstellung des Arbeitspunktes, die Kontrolle des Phasenunterschiedes und die Signaldetektion erfolgt erfindungsgemäss durch die Aufteilung der vor- und rückwärtslaufenden Wellen auf die zwei getrennten Faserzweige 20,20'.

Im folgenden werden der hierfür verwendete Detektor 5 und die Modulationseinheit anhand der Figur 3 näher beschrieben. Die rücklaufenden orthogonalen linear polarisierten Wellen gelangen durch den Detektionszweig 20' in den Detektor 5. Dieser weist einen vorzugsweise polarisations-unsensitiven Strahlteiler 51 auf, welche das Licht vorzugsweise im Verhältnis 1:1 aufteilt. Jedes der zwei resultierenden Paare orthogonaler Wellen wird in einem als Analysator wirkenden Polarisator 52 zur Interferenz gebracht und das resultierende Licht $I_+$ und $I_-$ in jeweils einer Photodiode 53 detektiert. Die Analysatoren 52 sind gegenüber den Faserachsen des Detektionszweigs 20' in einem Winkel von $\pm45°$ ausgerichtet, und zwar so, dass ihre eigenen Transmissionsrichtungen senkrecht zueinander stehen. Für die detektierten Photodiodensignale $I_+$ und $I_-$ gilt

$$I_\pm = I_0(1\pm K \cos(\triangle\Phi+\Delta\Theta))$$

wobei $I_0$ die Lichtintensität im Quadraturpunkt und *K* die Visibilität der Interferenzstreifen ist.

In einem Subtraktionselement 62 des Signalprozessors 6 wird die Differenz dieser zwei Photodiodensignale gebildet und einer Quadraturkontrolle 64 zugeführt. Diese Quadraturkontrolle 64 regelt den beziehungsweise die Phasenmodulatoren so, dass die Differenz im stromlosen Zustand und ohne äussere Einflüsse gleich Null ist. In diesem Fall ist der Quadraturpunkt Q erreicht. Diese Regelung erfolgt quasi-statisch, das heisst, es wird stets auf den Quadraturpunkt geregelt, wobei der Spannungswert bei allfälligem Drift des Arbeitspunktes oder bei langsamen durch externe Einflüsse induzierter Phasenverschiebungen angepasst wird. Hierfür reicht eine Quadraturkontrolle 64 mit einer geringen Frequenzbandbreite aus, beispielsweise von 5 Hz.

In einer bevorzugten Variante des Verfahrens wird jedoch zusätzlich auch die alternierende Phasenmodulation kompensiert, welche durch einen im Stromleiter S zu messenden Wechselstrom hervorgerufen wird. Hierfür ist eine Quadraturkontrolle mit einer grösseren Bandbreite notwendig, beispielsweise von 100 Hz, die auch die periodischen Schwankungen in der Differenz kompensiert. Diese Kompensation ist eine dynamische, closed-loop Kontrolle. In diesem Fall dient die von der Quadraturkontrolle erzeugte und an den Modulatoren 7, 7' anliegende Spannung gleichzeitig als Ausgangssignal des Sensors.

Es ist möglich, dass ein einziger Modulator sowohl für die quasi-statische wie auch die dynamische Kontrolle eingesetzt wird. In einer bevorzugten Ausführungsform sind jedoch zwei Modulatoren 7,7' vorhanden, wobei einer für die quasi-statische und der andere für die dynamische Kontrolle verwendet wird.

Falls die strom-induzierte Phasenmodulation nicht kompensiert wird, weist der Signalprozessor zur Messung des durch den Stromleiter L fliessenden Stroms ferner ein Additionselement 63 und ein Divisionselement 65 auf. Im stromdurchflossenen Zustand ist die erhaltene Differenz der Signale $I_+$, $I_-$ bei konstanter Lichtintensität proportional zum Strom. Die Summe der zwei Signale ist proportional zur Lichtintensität. Durch Division der Differenz durch die Summe im Divisionselement 65 wird als Detektionssignal 60

$$S=(I_+-I_-)/(I_+ + I_-)=K \sin(\Delta\Phi)\approx K\Delta\Phi$$

erhalten, welches nun unabhängig von der Lichtintensität $I_0$ ist, jedoch proportional zum Strom I ist.

In Figur 4 ist eine weitere Ausführungsform des erfindungsgemässen Stromsensors, beziehungsweise seiner Modulationseinheit dargestellt. Hier sind drei mindestens annähernd identische Strahlteiler 51, 51', 51'' vorhanden. Jeder der zwei rückwärtslaufenden Wellen hat somit eine Reflexion und eine Transmission in den Strahlteilern erfahren. Diese Anordnung weist den Vorteil auf, dass beide Wellen dieselben Variationen in den Eigenschaften der Strahlteiler erfahren, welche durch Alterungsprozesse, Temperaturschwankungen und andere externe Einflüsse verursacht werden.

Dank dem erfindungsgemässen Stromsensor lässt sich ein Detektionssignal erhalten, welches unabhängig von der Stabilität des Modulators und seiner Modulationseinheit ist. Dabei sind weitere Varianten der oben angeführten Beispiele möglich. So lässt sich anstelle einer spulenförmigen Sensorfaser auch ein integriert optisches Element als spulenförmigen optischen Sensor einsetzen. Die Spule kann in der faseroptischen wie auch in der integriert optischen Ausführung aus einer einzigen Windung bestehen. Ferner lässt sich anstelle eines polarisations-unsensitiven Strahlteilers und den zwei Analysatoren auch ein polarisierender Strahlteiler verwenden.

**Bezugszeichenliste**

L    Stromleiter

1    Sensorfaser
10   Reflektor
2    faseroptische Zuleitung
20   erster Faserzweig
20'  zweiter Faserzweig
21   Polarisator
22   Verzögerungsschlaufe
23   weiteres polarisationserhaltendes Fasersegment
3    Phasenverzögerungselement
4    Lichtquelle
5    Detektor
50   Dektorsignalleitung
51   Strahlteiler
52   Analysator
53   Photodiode
6    Signalprozessor
60   Sensorsignalleitung
61   Modulationssignalleitung
62   Subtraktionselement
63   Additionselement
64   Quadraturkontrolle
65   Divisionselement
7    Phasenmodulator
7'   Phasenmodulator
8    Koppler

**Patentansprüche**

**1.** Optischer Stromsensor

mit einem Reflexionsinterferometer, welches eine faseroptische Zuleitung (2) und einen spulenförmigen optischen Sensor (1) aufweist, wobei der Sensor (1) an einem ersten Ende mit der Zuleitung (2) verbunden und an einem zweiten Ende mit einem Reflektor (10) versehen ist,
mit mindestens einem Mittel zur Phasenverschiebung (7,7') einer differentiellen Phase zweier in der Zuleitung propagierenden zueinander orthogonal polarisierten optischen Wellen und mit einem Detektor (5),

**dadurch gekennzeichnet,**

**dass** die Zuleitung (2) einen polarisationserhaltenden ersten Faserzweig (20) für zwei vorwärtslaufende zueinander orthogonal polarisierten Wellen und einen polarisationserhaltenden zweiten Faserzweig (20') für zwei rückwärtslaufende zueinander orthogonal polarisierten Wellen aufweist, wobei die zwei Faserzweige (20,20') über einen sensorseitigen Koppler (8) miteinander verbunden sind und wobei der erste Faserzweig (20) mit einer Lichtquelle (4) und der zweite Faserzweig (20') mit dem Detektor (5) verbunden sind, und
**dass** das mindestens eine Mittel zur Phasenverschiebung (7) mit einem dieser zwei Faserzweige (20,20') wirkverbunden ist.

**2.** Stromsensor nach Anspruch 1, **dadurch gekennzeichnet, dass** die zwei Faserzweige (20,20') mit ihren Faserachsen so über den Koppler (8) miteinander verbunden sind, dass Polarisationsrichtungen von in den beiden Zweigen propagierenden optischen Wellen bezüglich der Faserachsen gegenseitig vertauscht sind.

**3.** Stromsensor nach Anspruch 1, **dadurch gekennzeichnet, dass** die zwei Faserzweige (20,20') mindestens annähernd dieselbe optische Länge aufweisen.

**4.** Stromsensor nach Anspruch 1, **dadurch gekennzeichnet, dass** das mindestens eine Mittel zur Phasenverschiebung (7) und der Detektor (5) mit einem Signalprozessor (6) verbunden sind, welcher ein Mittel (62,64) zur Quadraturkontrolle und Kompensation einer quasi-statischen Phasenverschiebung aufweist.

**5.** Stromsensor nach Anspruch 1, **dadurch gekennzeichnet, dass** das mindestens eine Mittel zur Phasenverschiebung (7) und der Detektor (5) mit einem Signalprozessor (6) verbunden sind, welcher ein Mittel (62,64) zur Kompensation einer von einem zu messenden Wechselstrom induzierten Phasenverschiebung aufweist.

**6.** Stromsensor nach Anspruch 1, **dadurch gekennzeichnet, dass** zwei Mittel zur Phasenverschiebung (7,7') vorhanden sind, wobei jedes einem anderen Faserzweig (20,20') zugeordnet ist.

**7.** Stromsensor nach den Ansprüchen 4-6, **dadurch gekennzeichnet, dass** beide Mittel zur Phasenverschiebung (7,7') mit demselben Signalprozessor (6) verbunden sind.

**8.** Stromsensor nach Anspruch 1, **dadurch gekennzeichnet, dass** der Detektor (5) drei Strahlteiler (51,51',51") aufweist, welche so angeordnet sind, dass jede der rückwärtslaufenden Wellen eine Reflektion und eine Transmission durch die Strahlteiler erfährt.

**9.** Verfahren zur Einstellung eines Arbeitspunktes in einem optischen Stromsensor mit einem Reflexionsinterferometer nach einem der Ansprüche 1 bis 7, wobei der Stromsensor zwei Faserzweige (20,20') aufweist, **dadurch gekennzeichnet, dass** in einem der zwei Faserzweige (20) vorwärtslaufende zueinander orthogonal linear polarisierte Wellen und im anderen Faserzweig (20') rückwärtslaufende, zueinander orthogonal linear polarisierte Wellen propagieren und dass in mindestens einem Faserzweig (20,20') eine Verschiebung der Phasen der darin propagierenden Wellen geregelt wird.

10. Verfahren nach Anspruch 9, **dadurch gekennzeichnet, dass** der Arbeitspunkt quasi-statisch auf den Quadraturpunkt eingestellt wird.

11. Verfahren nach Anspruch 9, **dadurch gekennzeichnet, dass** der Arbeitspunkt auf den Quadraturpunkt eingestellt und periodische, durch den zu messenden Strom hervorgerufene Phasenverschiebungen kompensiert werden.

12. Verfahren nach Anspruch 10 oder 11, **dadurch gekennzeichnet, dass** das rückwärtslaufende zueinander orthogonal linear polarisierte Wellenpaar in zwei Wellenpaare aufgeteilt wird und jedes resultierende Wellenpaar in einem Analysator zur Interferenzgebracht wird, wobei die Durchlassrichtungen der Analysatoren unter $90°$ zueinander stehen, dass zwei erhaltene Interferenzsignale detektiert werden, dass eine Differenz der Interferenzsignale gebildet wird und dass die Differenz auf Null geregelt wird.

13. Verfahren zur Strommessung mittels eines optischen Stromsensors mit einer Reflexionskonfiguration nach einem der Ansprüche 1 bis 7, wobei der Stromsensor zwei Faserzweige (20,20') aufweist, **dadurch gekennzeichnet, dass** in einem der zwei Faserzweige (20) vorwärtslaufende orthogonal linear polarisierte Wellen und im anderen Faserzweig (20') rückwärtslaufende, orthogonal linear polarisierte Wellen propagieren, dass in mindestens einem Faserzweig (20,20') ein Unterschied der Phasen der darin propagierenden Wellen geregelt wird, dass das rückwärtslaufende zueinander orthogonal linear polarisierte Wellenpaar in zwei Wellenpaare aufgeteilt wird und jedes resultierende Wellenpaar in einem Analysator zur Interferenz gebracht wird, wobei die Durchlassrichtungen der Analysatoren unter $90°$ zueinander stehen, dass zwei erhaltene Interferenzsignale detektiert werden, dass eine Summe und eine Differenz der Interferenzsignale gebildet wird und dass die Differenz durch die Summe dividiert wird, um ein dem zu messenden Strom mindestens annähernd proportionales Signal zu erhalten.

**Fig. 1**

EP 1 174 719 A1

Fig. 3

**Fig. 2**

EP 1 174 719 A1

**Fig. 4**

Europäisches
Patentamt

**EUROPÄISCHER RECHERCHENBERICHT**

Nummer der Anmeldung

EP 00 81 0605

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| Y,D | FROSIO G ET AL: "RECIPROCAL REFLECTION INTERFEROMETER FOR A FIBER-OPTIC FARADAY CURRENT SENSOR" APPLIED OPTICS,US,OPTICAL SOCIETY OF AMERICA,WASHINGTON, Bd. 33, Nr. 25, 1. September 1994 (1994-09-01), Seiten 6111-6122, XP000473296 ISSN: 0003-6935 * Zusammenfassung; Abbildungen 1,2 * * Seite 6112, linke Spalte, Absatz 3 - rechte Spalte, Absatz 2 * --- | 1,9,13 | G01R15/24 |
| A | WO 99 17129 A (TEXAS A & M UNIVERSITY SYST) 8. April 1999 (1999-04-08) * Zusammenfassung; Abbildung 1 * --- | 1,9,13 | |
| Y | EP 0 569 700 A (ASEA BROWN BOVERI) 18. November 1993 (1993-11-18) * Zusammenfassung; Abbildung 5 * * Seite 8, Zeile 22 - Zeile 53 * --- | 1,9,13 | RECHERCHIERTE SACHGEBIETE (Int.Cl.7) |
| A | CH 671 638 A (BBC BROWN BOVERI & CIE) 15. September 1989 (1989-09-15) * Anspruch 8; Abbildungen 3A-C * ----- | 1,9,13 | G01R G02B |

Der vorliegende Recherchenbericht wurde für alle Patentansprüche erstellt

| Recherchenort | Abschlußdatum der Recherche | Prüfer |
|---|---|---|
| BERLIN | 23. Oktober 2000 | Fritz, S |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

....................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 00 81 0605

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-10-2000

| Im Recherchenbericht angeführtes Patentdokument | Datum der Veröffentlichung | Mitglied(er) der Patentfamilie | Datum der Veröffentlichung |
|---|---|---|---|
| WO 9917129 A | 08-04-1999 | US 5987195 A<br>AU 9678498 A<br>EP 1019745 A | 16-11-1999<br>23-04-1999<br>19-07-2000 |
| EP 0569700 A | 18-11-1993 | DE 4216152 A<br>DE 59309447 D<br>JP 6034671 A<br>US 5343036 A | 18-11-1993<br>22-04-1999<br>10-02-1994<br>30-08-1994 |
| CH 671638 A | 15-09-1989 | KEINE | |

Für nähere Einzelheiten zu diesem Anhang : siehe Amtsblatt des Europäischen Patentamts, Nr.12/82